(19) **Europäisches Patentamt / European Patent Office / Office européen des brevets**

(11) **EP 4 670 903 A1**

(12) **EUROPEAN PATENT APPLICATION**
published in accordance with Art. 153(4) EPC

(43) Date of publication:
**31.12.2025  Bulletin 2026/01**

(21) Application number: **24759698.4**

(22) Date of filing: **21.02.2024**

(51) International Patent Classification (IPC):
**B23K 35/30** $^{(2006.01)}$   **B23K 35/02** $^{(2006.01)}$

(52) Cooperative Patent Classification (CPC):
**B23K 35/02; B23K 35/30; B23K 35/40**

(86) International application number:
**PCT/CN2024/077900**

(87) International publication number:
**WO 2024/175021 (29.08.2024 Gazette 2024/35)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **22.02.2023  US 202363486345 P**

(71) Applicant: **The University of Hong Kong**
**Hong Kong 999077 (HK)**

(72) Inventors:
• **HUANG, Mingxin**
  **Hong Kong 999077 (CN)**
• **WANG, Yi**
  **Hong Kong 999077 (CN)**

(74) Representative: **Patentanwälte**
**Ruff, Wilhelm, Beier, Dauster & Partner mbB**
**Kronenstraße 30**
**70174 Stuttgart (DE)**

(54) **SOLDERING LUG, SOLDERING ASSEMBLY AND PREPARATION METHOD THEREFOR**

(57) The present invention relates to a bonding sheet, a bonded assembly, and preparation methods therefor. The bonding sheet comprises: a copper substrate having opposing first and second surfaces; and at least one nano-metal layer deposited on at least one of the first and second surfaces of the copper substrate, the yield strength of the bonding sheet is not greater than 100 MPa. The bonded assembly comprises: a first substrate; a second substrate; and a bonding portion located between the first substrate and the second substrate to connect the two, the bonding portion comprises a copper substrate, a first bonded interface on a first side of the copper substrate, and a second bonded interface on a second side of the copper substrate opposite to the first side, the first bonded interface and the second bonded interface are formed by bonding nano-metal on opposite sides of the copper substrate to the first substrate and the second substrate, respectively; and the shear strength of the bonded assembly is not less than 40 MPa.

Fig.9

**Description**

**Field of the Invention**

The present invention relates to a bonding sheet, which can be used for packaging high-power components to be bonded, comprising a copper substrate and a nano-metal layer deposited on at least one outer surface of the copper substrate. The present invention further relates to a bonded assembly formed by bonding using the bonding sheet, as well as corresponding preparation methods for the bonding sheet and the bonded assembly.

**Background of the Invention**

Currently, with the development of high-power components toward functional diversification and miniaturization, the packaging of high-power components faces significant challenges. The U.S. Department of Energy predicted that the energy per unit volume of high-power components onboard the vehicles would increase from 18 kW/L in 2020 to 100 kW/L by 2025. The increase in power density directly leads to an increase in the operating temperature of the high-power components. To meet the demand for higher power density, high-power components have evolved from first-generation silicon-based semiconductors to third-generation wide-bandgap silicon carbide semiconductors, with operating temperatures rising accordingly from 100 °C to 175 °C, and further increases are expected in the future. This poses a challenge to traditional welding materials, as they cannot perform robustly at high temperatures, thereby limiting the increase in power density of high-power components. For example, tin-based solder paste with a melting point of 250 °C is currently used in device packaging. Such traditional solder can only withstand device operating temperatures below 150°C. Beyond this temperature, the reliability of the interconnection of the tin-based solder paste will significantly decrease, leading to premature device failure and short circuit. Therefore, new high-temperature-resistant welding materials, primarily nano-silver, nano-copper, are gradually replacing traditional welding materials in the mainstream market.

CN110640354 A describes a preformed solder, comprising a preformed metal substrate and a nano-particle film coated on the outer surface of the substrate; the nano-particle film mainly contains nano-metal particles and is pre-baked to coat the preformed surface, and the melting point of the nano-metal particles is lower than that of the metal substrate. Due to the loose structure and uniform pores of the nano-particle film, it can better compensate for the flatness and surface roughness of the component to be soldered (such as chip, copper-clad ceramic substrate, or surface of heat sink ), so that pressure can be transmitted more evenly to each soldering area during the soldering process, and internal stresses generated during soldering or drying can be absorbed by the pores and would not accumulate in the nano-particle film. However, it is worth noting that the inherently loose structure of the nano-metal particles results in excessive pores in the final soldering portion, which not only leads to poor thermal conductivity and poor electrical conductivity but also adversely affects the shear strength of the soldered assembly. In addition, since the pre-baked nano-particle layer cannot deform elastically and has poor adhesion to the substrate, secondary processing of the solder in terms of shape is not possible, causing inconvenience in use.

WO2022/127776A1 describes a low-temperature soldering method using a nano-copper layer, which involves depositing the nano-copper layer on the surface of one or more structures to be soldered, wherein the nano-copper layer has a thickness of 10 nm to 10 μm and a grain size of 5 to 500 nm. Compared with CN110640354 A, the coating is dense and free of pores, eliminating the porosity defect of the nano-metal particle structure and improving electrical conductivity and thermal conductivity. However, the inventors of the present invention have found that in order to achieve high shear strength, the requirement for the flatness of the components to be soldered is very high.

In view of the above, there still exists a need to improve solders to enhance the shear strength of the soldered assembly.

**Summary of the Invention**

The present invention is made in view of the above-mentioned problems existing in the prior art.

A first aspect of the present invention provides a bonding sheet. While the surface coating has low porosity and the flatness requirement for the component to be bonded is not high, the bonding sheet enables the finished bonded assembly to have a high effective bonded area and shear strength, improving the bonding reliability.

The bonding sheet of the present invention comprises:

a copper substrate having opposing first and second surfaces; and
at least one nano-metal layer deposited on at least one of the first and second surfaces of the copper substrate, wherein a yield strength of the bonding sheet is not greater than 100 MPa.

A bonding surface of a component to be bonded, such as a chip, typically exhibits ups and downs (i.e., roughness) without special treatment. During the preparation of bonding sheets, the inventors have found that in the case of a bonding sheet formed by depositing a dense nano-copper layer on a conventional substrate, the shear strength of the assembly bonded with it is not high enough. Through research, the inventors have found that this is because the dense nano-copper layer on the surface, unlike a nanoparticle layer, cannot rely on particle dislocation or pore deformation to achieve synchronized deformation of the copper layer. Consequently, it cannot compensate for ups and downs on the surface of the component to be bonded, leading to obviously non-conforming portions, i.e., a reduction in the effective bonded area. Therefore, only partial bonding can be achieved between the components to be bonded, resulting in a low shear strength.

To overcome this defect, wet polishing operation can be performed to improve the flatness of the bonding surface, thereby effectively increasing the bonded area and in turn enhancing the shear strength. However, this operation is not only costly but also causes some degree of damage to the component to be bonded. Therefore, it is not a preferred measure for improving the shear strength of the bonded assembly.

Thus, the present invention aims to provide a solution for increasing the shear strength of the bonded assembly without requiring special treatment (e.g., wet polishing) of the bonding surface of the component to be bonded. The invention uses a copper substrate as a substrate of a bonding sheet. By modeling surface morphology of a component to be bonded (e.g., a chip)-where when the component to be bonded is placed horizontally, the perpendicular difference between the highest and lowest points on its outer surface can reach up to 200 nm (i.e., a rough surface)-the yield strength of the copper substrate corresponding to its yield point under a thermocompression bonding pressure (15~40 MPa) is calculated. This yield strength serves as a basis for selecting the copper substrate, ensuring that the bonding sheet undergoes at least partial plastic deformation during thermocompression bonding. Through theoretical research and experimental validation, the inventors have found that the yield strength of the bonding sheet should not exceed 100 MPa. Under this circumstance, during thermocompression bonding, a bonding sheet contacts protrusions on a surface of a chip. Due to small contact area and high pressure, the yield strength of the bonding sheet can be reached easily, enabling the bonding sheet to undergo localized plastic deformation around the protrusions, whereby recesses on the surface of the chip can become into contact with the deformed bonding sheet, enabling diffusion bonding. This achieves the purpose of increasing the effective bonded area, thereby enhancing the shear strength of the finished bonded assembly. Conversely, if the bonding sheet's yield strength exceeds 100 MPa, minimal or no plastic deformation of the bonding sheet occurs, making it difficult to compensate for the significant surface flatness variations of the component to be bonded. As a result, the effective bonded area cannot be increased significantly, leading to a low shear strength. Therefore, the present invention requires that the yield strength of the bonding sheet should not be higher than 100 MPa. Preferably, the yield strength of the bonding sheet is in the range of 18 to 100 MPa, yet preferably in the range of 18 to 67.5 MPa, further preferably in the range of 20 to 46.5 MPa, and yet further preferably in the range of 23 to 36 MPa.

Preferably, an average grain size of the copper substrate is in the range of 30 to 140 $\mu$m, preferably in the range of 50 to 140 $\mu$m, more preferably in the range of 75 to 122.5 $\mu$m, and still more preferably in the range of 92 to 115 $\mu$m.

Preferably, an elongation of the bonding sheet is not less than 11.5%, preferably not less than 23%, yet preferably in the range of 27.5% to 36%, and more preferably in the range of 29% to 34%.

Preferably, the bonding sheet is in the form of a thin plate, which can be cut subsequently into desired dimensions or shapes. Compared to a nanoparticle layer which is dried after being applied, cutting or bending would not cause peeling of the nano-metal layer on the bonding sheet, thereby improving the integrity of the bonding sheet and expanding the application scenarios of the bonding sheet.

Preferably, an average grain size of the nano-metal layer is in the range of 5 to 500 nm, preferably in the range of 5 to 100 nm, to achieve the purpose of low-temperature bonding and enhance bonding performance at the bonded interface. Preferably, an average thickness of the nano-metal layer is in the range of 100 nm to 10 $\mu$m, more preferably in the range of 500 nm to 5 $\mu$m. Preferably, the nano-metal layer may be formed from a metal selected from: copper, gold, nickel, silver, platinum and titanium. Preferably, the nano-metal layer is a nano-copper layer.

A second aspect of the present invention provides a method for preparing a bonding sheet, comprising:

Step A: providing a copper substrate having opposing first and second surfaces;
Step B: annealing the copper substrate under vacuum to obtain an annealed copper substrate, an average grain size of the annealed copper substrate being in the range of 30 to 140 $\mu$m;
Step C: depositing at least one nano-metal layer on at least one of the first and second surfaces of the annealed copper substrate to obtain the bonding sheet.

The method involves simple processes and does not require complex or expensive equipment.

Preferably, the copper substrate is a conventional industrial-grade electrodeposited copper foil or rolled copper foil with a yield strength typically in the range of 140 to 250 MPa. The present invention first subjects the copper foil to an annealing treatment, enabling it to fully recrystallize to an average grain size of 30 to 140 $\mu$m, thus obtaining an annealed copper foil. The yield strength of the annealed copper foil does not exceed 100 MPa, so that the yield strength of the resulting bonding sheet is not higher than 100 MPa.

It is well known that, at the same annealing temperature, a longer holding time leads to a larger final average grain size. For the same holding time, a higher annealing temperature results in a larger final average grain size. Therefore, based on the target average grain size of 30 to 140 $\mu$m, heat treatment conditions can be anticipated. Preferably, in Step B, vacuum degree is $1.0 \times 10^{-3}$ Torr, an annealing temperature is 400 to 850°C, and holding time is 2 to 16 hours; yet preferably, the annealing temperature is 500 to 800°C, and the holding time is 6 to 12 hours. For lower annealing temperatures, such as 400°C, if the holding time is too short, it is not enough for the average grain size to grow to 30 $\mu$m. Therefore, a minimum holding time of 2 hours is required. Conversely, for higher annealing temperatures, such as 850°C, if the holding time is too long, the average grain size will exceed the expected range, adversely affecting the shear strength of the final device. Therefore, the holding time should not exceed 16 hours, which also helps shorten the overall process flow, improving production line's yield.

Preferably, prior to Step C, a cleaning step is included as follows: the annealed copper substrate is cleaned with a 1:1 (vol/vol) mixture of dilute hydrochloric acid and deionized water for 30 seconds to remove surface oxides, followed by ultrasonic cleaning in deionized water and drying-for example, blow-drying at room temperature using a nitrogen gun.

Preferably, the deposition of the nano-metal layer onto the copper substrate is performed via electroplating, evaporation, vapor deposition (e.g., magnetron sputtering), ion plating, etc., to achieve a dense nano-metal layer having a relatively uniform thickness and grain size. The thickness and grain size of the nano-metal layer are selected such that, after deposition onto the copper substrate, they do not significantly change the yield strength of the overall bonding sheet, so as to ensure that the yield strength of the overall bonding sheet is predominantly governed by the copper substrate and does not exceed 100 MPa. Therefore, if a thicker nano-metal layer (e.g., 10 $\mu$m) is to be used, a thicker copper substrate having a lower yield strength (i.e., larger grain size) should be selected to ensure that the yield strength of the overall bonding sheet obtained after depositing the nano-metal layer is not higher than 100 MPa.

Preferably, the average thickness of the nano-metal layer is in the range of 100 nm to 10 $\mu$m, more preferably in the range of 500 nm to 5 $\mu$m. Preferably, the average grain size of the nano-metal layer is in the range of 5 to 500 nm, preferably in the range of 5 to 100 nm, to achieve the purpose of low-temperature bonding and enhance the bonding performance at the bonded interface.

Preferably, the average thickness of the copper substrate is at least 10 times that of the nano-metal layer, preferably 50 to 600 times, and further preferably 100 to 400 times. The average grain size of the copper substrate is at least 60 times that of the nano-metal layer, preferably at least 100 times, to ensure that the yield strength of the bonding sheet is predominantly governed by the copper substrate.

Preferably, the nano-metal layer may be made from a metal selected from: copper, gold, nickel, silver, platinum and titanium. Preferably, the nano-metal layer is a nano-copper layer.

Preferably, the nano-copper layer is formed by electroplating deposition as follows: the electrolytic solution contains 100 to 150 g/L of anhydrous copper sulfate, 80 to 150 g/L of 98 wt.% concentrated sulfuric acid, 50 to 150 mg/L of sodium chloride, 350 to 480 mg/L of PEG20000, and 20 to 40 mg/L of Janus Green B. Preferably, current density of electroplating deposition is 0.05 to 0.15 A/cm$^2$, and a deposition time is 10 to 300 seconds.

A third aspect of the present invention lies in a bonded assembly, comprising:

a first substrate;
a second substrate; and
a bonding portion located between the first substrate and the second substrate to connect the two, wherein the bonding portion comprises a copper substrate, a first bonded interface on a first side of the copper substrate, and a second bonded interface on a second side of the copper substrate opposite to the first side, the first bonded interface and the second bonded interface being formed by bonding nano-metal on the opposite sides of the copper substrate with the first substrate and the second substrate, respectively,
wherein a shear strength of the bonded assembly is not less than 40 MPa.

Preferably, an average grain size of the copper substrate is in the range of 30 to 140 $\mu$m, preferably in the range of 50 to 140 $\mu$m, preferably in the range of 75 to 122.5 $\mu$m, and yet preferably in the range of 92 to 115 $\mu$m.

Preferably, the first substrate and/or the second substrate may be a chip, copper-clad ceramic substrate, or heat sink, etc.

Preferably, an effective bonded area of the first bonded interface and/or the second bonded interface is not less than 67.5% of the total interface area, preferably not less than 76%, preferably not less than 86%, and preferably not less than 92.5%.

Preferably, the shear strength of the bonded assembly is not less than 45 MPa, yet preferably not less than 50 MPa, and further preferably the shear strength is not less than 55 MPa.

A fourth aspect of the present invention lies in a method for producing a bonded assembly, comprising:

Step A: providing a first substrate having a first outer surface, a second substrate having a second outer surface, and a bonding sheet, wherein the bonding sheet comprises: a copper substrate having opposing first and second surfaces; a first nano-metal layer on the first surface of the copper substrate; and a second nano-metal layer on the second surface of the copper substrate opposite to the first surface, wherein a yield strength of the bonding sheet is not greater than 100 MPa;

Step B: arranging the first nano-metal layer of the bonding sheet in surface contact with the first outer surface of the first substrate and the second nano-metal layer of the bonding sheet in surface contact with the second outer surface of the second substrate to form a stacked structure;

Step C: performing thermocompression bonding on the stacked structure to bond the first substrate, the second substrate, and the bonding sheet together, thereby obtaining the bonded assembly, wherein a shear strength of the bonded assembly is not less than 40 MPa.

Preferably, in Step C, the thermocompression bonding is performed as follows: a pressure of 15 to 40 MPa is applied from above and below the stacked structure in a helium-protected environment at a bonding temperature of 250 to 350°C, for a bonding time of 10 to 30 minutes. Further preferably, the bonding temperature is 250 to 300°C, or the pressure is 20 to 30 MPa, or the bonding time is 10 to 20 minutes.

Preferably, when the first substrate and/or the second substrate is placed horizontally, the perpendicular difference between the highest point and the lowest point on the first outer surface and the second outer surface can reach up to 200 nm, eliminating the need for additional treatment of the surface to achieve high flatness.

The description and preferred embodiments of the bonding sheet in the first aspect of the present invention are applicable to the second, third, and fourth aspects of the invention.

Based on the above, compared with prior art, the present invention achieves the following technical effects:

1) By softening the copper substrate to control the yield strength of the bonding sheet, the present invention enables the bonding sheet to increase the effective bonded area at the bonded interface without flattening treatment (e.g., wet polishing) of rough bonding surface (where the perpendicular difference between the highest point and the lowest point can reach up to 200 nm when the bonding surface is placed horizontally), thereby enhancing the shear strength after bonding, and improving bonding reliability. As a result, the bonding sheet of the present invention exhibits higher tolerance for roughness of the bonding surface and achieves higher shear strength;

2) Compared to bonding sheets made from nano-copper particle films, the surface nano-metal layer in the present invention is highly dense, which improves both thermal conductivity and electrical conductivity of the bonded assembly; and

3) The bonding sheet of the present invention exhibits stronger adhesion between the copper substrate and the overlying nano-metal layer, allowing for secondary processing (e.g., cutting) of the bonding sheet to obtain application-specific dimensions and shapes to suit the intended applications scenarios, without the nano-metal layer peeling off as in the case of nano-copper particle film.

**Description of the Drawings**

Exemplary embodiments of the present invention will now be described with reference to the accompanying drawings, in which:

Fig. 1 shows height variation of a bonding surface of an exemplary chip in the perpendicular direction measured by an atomic force microscope (AFM), where y represents the height in the perpendicular direction and x represents the length in the horizontal direction;

Fig. 2 shows a comparison of the morphology of a chip model and a bonding sheet model before and after pressure application in Bonding Simulation 1;

Fig. 3 shows a comparison of the morphology of the chip model and bonding sheet model before and after pressure application in Bonding Simulation 2;

Fig. 4 shows a comparison of the morphology of the chip model and bonding sheet model before and after pressure application in Bonding Simulation 3;

Fig. 5 shows a comparison of morphology of the chip model and bonding sheet model before and after pressure application in Bonding Simulation 4;

Fig. 6 shows a scanning electron microscope (SEM) image of a surface morphology of an annealed copper substrate of Sample 1 in Example S1;

Fig. 7 shows a scanning acoustic microscope (SAM) image of a bonding sheet of Sample 1 in Example S1 after bonding with the chip;

Fig. 8 shows an SEM image of a surface morphology of an annealed copper substrate of Sample 1 in Example S2;

Fig. 9 shows an SEM cross-sectional view of a bonding sheet of Sample 1 in Example S2, where a W-Pt layer is a protective layer for focused ion beam sample preparation and is not included in the original structure;

Fig. 10 shows an SEM image of a surface morphology of a nano-copper layer of the bonding sheet of Sample 1 in Example S2;

Fig. 11 shows an SAM image of a bonding sheet of Sample 1 in Example S2 after bonding with the chip;

Fig. 12 shows an SEM image of a surface morphology of an annealed copper substrate of Sample 1 in Example S3;

Fig. 13 shows an SAM image of a bonding sheet of Sample 1 in Example S3 after bonding with the chip;

Fig. 14 shows an SEM image of a surface morphology of an annealed copper substrate of Sample 1 in Example S4;

Fig. 15 shows an SAM image of a bonding sheet of Sample 1 in Example S4 after bonding with the chip;

Fig. 16 shows an SEM image of a surface morphology of an annealed copper substrate of Sample 1 in Example S5;

Fig. 17 shows an SAM image of a bonding sheet of Sample 1 in Example S5 after bonding with the chip;

Fig. 18 shows an SEM image of a surface morphology of an annealed copper substrate of Sample 1 in Example S6;

Fig. 19 shows an SAM image of a bonding sheet of Sample 1 in Example S6 after bonding with the chip;

Fig. 20 shows an SEM image of a surface morphology of an annealed copper substrate of Sample 1 in Example S7;

Fig. 21 shows an SAM image of a bonding sheet of Sample 1 in Example S7 after bonding with the chip;

Fig. 22 shows an SEM image of a surface morphology of a copper substrate of Sample 1 in Comparative Example C1;

Fig. 23 shows an SAM image of a bonding sheet of Sample 1 in Comparative Example C1 after bonding with the chip;

Fig. 24 shows an SEM image of a surface morphology of a copper substrate of Sample 1 in Comparative Example C2;

Fig. 25 shows an SAM image of a bonding sheet of Sample 1 in Comparative Example C2 after bonding with the chip;

Fig. 26 shows the relationships between the average yield strength of the bonding sheet and the average shear strength of the bonded assembly (a), the average effective bonded area ratio (b), the average grain size of the copper substrate (c), and the average elongation of the bonding sheet (d).

**Detailed Description**

The present invention will be described in further detail below with reference to exemplary embodiments. The following embodiments or experimental data are intended to illustrate the invention by way of example, and those skilled in the art should understand that the present invention is not limited to these embodiments or experimental data. Features or elements described in connection with or relating to one embodiment are applicable to all embodiments unless there is incompatibility between the features. One or more features or elements from one embodiment may be incorporated into or combined with any other embodiment disclosed herein, which may include extracting said one or more features or elements from said one embodiment to supplement or replace one or more features or elements of said other embodiment. A feature or combination of features of an embodiment disclosed herein may be extracted independently of other features of the embodiment. Alternatively, a feature or combination of features of an embodiment may be omitted from the embodiment.

Those skilled in the art will understand that any range or any value within the various ranges described herein is applicable to the present invention. For example, a yield strength of a bonding sheet in the range of 18 to 100 MPa means that any range or specific numerical value within this range may be selected. For example, the yield strength is in any of the ranges such as 18 to 95 MPa, 21 to 90 MPa, 28 to 90 MPa, 20 to 80 MPa, 22 to 70 MPa, 19 to 60 MPa, 20 to 55 MPa, 22 to 64 MPa, 25 to 42 MPa, 25 to 60 MPa, 28 to 82 MPa, or 23 to 58 MPa, or the yield strength is of any of the values such as 23 MPa, 25 MPa, 26 MPa, 30 MPa, 35 MPa, 40 MPa, 42 MPa, 48 MPa, 55 MPa, 60 MPa, 65 MPa, 70 MPa, 76 MPa, 80 MPa, 88 MPa, 94 MPa.

Yield strength, tensile strength, and elongation herein have the meanings commonly understood in the field. Specifically, yield strength refers to the limit of elastic behavior and the start of plastic deformation of a sample, i.e., a stress value at which the sample undergoes 0.2% deformation; tensile strength refers to a stress value at which the sample exhibits maximum uniform plastic deformation; and elongation refers to the deformation capacity of a material before fracture under stress, calculated as the percentage ratio of the total deformation $\Delta L$ of a gauge length after tensile fracture to the original gauge length $L$.

The shear fracture testing method herein is as follows: a bonded assembly comprises a first substrate and a bonding sheet bonded together, with a bonded interface size of $10 \times 10$ mm. The surface of the unbonded side of the bonding sheet is fixed to a test platform using resin. A movable mechanical component presses against a lateral surface of the first substrate. A shear force is applied parallel to the bonded assembly at a moving speed of 1 mm/min. Five samples of each bonded assembly are tested to take an average value.

The effective bonded area ratio herein is measured as follows: an acoustic scan is performed on a bonded assembly with a bonded area of $10 \times 10$ mm, wherein dark regions represent effective bonded regions and bright regions represent delaminated regions, i.e., unsuccessfully bonded regions. The effective bonded area ratio is obtained by calculating the ratio of the area of effective bonded regions to the total bonded area.

By controlling the yield strength of the bonding sheet, the present invention enables a bonding sheet to undergo localized yielding and deformation during bonding, thereby conforming to a bonding surface of a component to be bonded.

This improves an effective bonded area and enhances bonded strength, solving the problem of low shear strength caused by dense metal layers failing to adapt to the surface roughness of the component to be bonded.

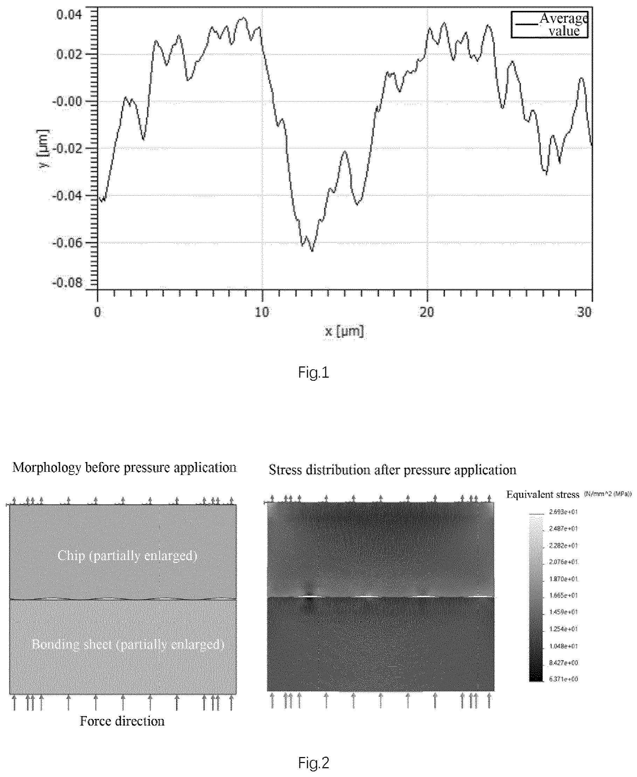

Specifically, to solve the above problems, the present invention conducts a simulation-based estimation of the required yield strength for a bonding sheet. Taking a conventional chip as an example of a component to be bonded, the inventors have used an atomic force probe to measure the roughness of the bonding surfaces of different chips. The results show periodic wavy undulations in the direction perpendicular to the bonding surfaces of the chips. The roughness Ra is 20 to 52 nm, and the perpendicular difference between the highest point and the lowest point ranges from 56 to 150 nm. Fig. 1 illustrates the height undulations of a bonding surface of an exemplary chip in the direction perpendicular to the bonding surface. To quantify these undulations, the values in the perpendicular direction of wavy undulations shown in Fig. 1 can be simplified and simulated using the following curve:

$$y(\mu m) = 0.05 * \sin(\frac{2*\pi*x}{10}) \qquad \text{Equation 1}$$

where y represents the surface undulations of the chip in the thickness direction (i.e., direction perpendicular to the bonded surface), and x represents the length along the bonding surface.

To simulate thermocompression bonding, the measured maximum roughness is used as an experimental reference, i.e., Ra = 52 nm, with a perpendicular difference of approximately 150 nm between the highest and lowest points. To enhance the product's fault tolerance, the perpendicular difference between the highest and lowest points is 200 nm in the simulation experiment, i.e., a roughness greater than Ra = 52 nm, and periodic length is 10 $\mu$m. The following curve is obtained:

$$y(\mu m) = 0.10 * \sin(\frac{2*\pi*x}{10}) \qquad \text{Equation 2}$$

The above curve is used to simulate the undulations of the bonding surface of the chip.

The bonding simulation steps are as follows:

1) A chip model and a bonding sheet model are constructed using modeling software SolidWorks, wherein a bonding surface of the chip model is a rough surface, i.e., the perpendicular difference between the highest and lowest points is 200 nm. The bonding sheet model comprises a copper substrate and a nano-copper layer provided on the copper substrate. The simulation assumes that as long as the chip model and the bonding sheet model can conform to each other, diffusion can happen to achieve bonding. Therefore, in the simulation, the bonding sheet is considered as a whole in terms of its yield strength.

2) The nano-copper layer of the bonding sheet model is brought into contact with the bonding surface of the chip model to simulate an initial state before thermocompression. Here, due to the roughness of the bonding surface, only protrusions of the bonding surface makes contact with the nano-copper layer. Therefore, there are unjoined regions between the two. The unjoined regions are shown as white regions in the figures.

3) Starting from the initial state, pressure is applied in the perpendicular direction in the software in a finite element simulation. The stress and strain near the bonded interface of the chip model and the bonding sheet model under the perpendicular pressure are calculated. Based thereon, the yield strength range that is required to achieve sufficient plastic deformation under the same pressure to conform to the chip's surface roughness is determined.

In all simulations, the material mechanical parameters used by the chip model are metallic material parameters built in the database; and the bonding sheet model uses copper material parameters with yield strength and tensile strength adjusted through annealing. The pressure range used in the simulated bonding is selected based on typical copper sintering welding pressures, i.e., 15-40 MPa.

Simulation 1: the yield strength of the bonding sheet model is 258 MPa. A pressure equivalent to 15 MPa is applied to a bottom of the bonding sheet model in the direction shown in Fig. 2 (i.e., perpendicular to the bonding surface), while a top position of the chip is limited so as to perform static stress analysis. Fig. 2 shows a comparison of the morphology of the bonded interface before and after pressure application, wherein the left image shows white regions between the nano-copper layer of the bonding sheet model and the bonding surface of the chip model. They are unjoined regions between the two. The right image also shows white regions in the same locations, indicating that the unjoined regions that exist before the pressure application remain unjoined after the pressure application. In addition, the right image shows stress distribution in the system after pressure application. By comparing the gray level in regions of the bonding sheet with a grayscale bar on the right, it can be known that at the bonded interface, the stress in the contact area between the bonding surface of the chip and the bonding sheet ranges from 9 to 13.6 MPa, far below the yield strength of the bonding sheet model (258 MPa). As a result, the bonding sheet model cannot undergo plastic deformation to compensate for the undulations of the surface of the chip. It can thus be determined that, under a bonding pressure of 15 MPa, the yield strength of the bonding sheet at least needs to be less than 13.6 MPa in order for the bonding sheet to yield and conform to the bonding surface of the chip.

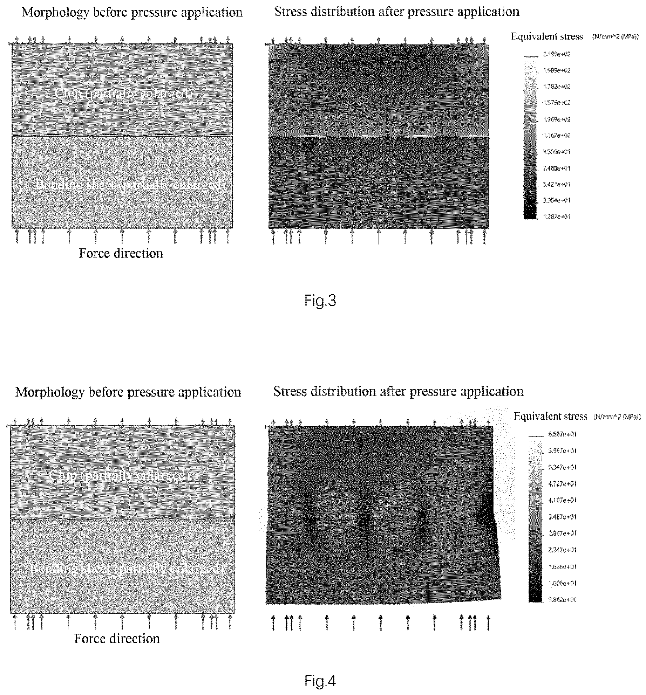

Simulation 2: the yield strength of the bonding sheet model is 258 MPa. A pressure equivalent to 40 MPa is applied to a bottom of the bonding sheet model in the direction shown in the figure (i.e., perpendicular to the bonding surface), while a top position of the chip is limited so as to perform static stress analysis. Fig. 3 shows a comparison of the morphology of the bonded interface before and after pressure application. Similar to Fig. 2, the unjoined regions in Fig. 3 show no significant change before and after pressure application. In addition, the stress distribution in the system after pressure application shows that at the bonded interface, the stress in the contact area between the bonding surface of the chip and the bonding sheet ranges from 76.8 to 152 MPa, far below the yield strength of the bonding sheet model (258 MPa). As a result, the bonding sheet cannot undergo plastic deformation to compensate for the roughness undulations on the chip. Similarly, it can thus be determined that, under a bonding pressure of 40 MPa, the yield strength of the bonding sheet at least needs to be less than 152 MPa in order for the bonding sheet to yield and conform to the bonding surface of the chip.

Simulation 3: the yield strength of the bonding sheet model is 18 MPa. A pressure equivalent to 15 MPa is applied to a bottom of the bonding sheet model in the direction shown in the figure (i.e., perpendicular to the bonding surface), while a top position of the chip is limited so as to perform static stress analysis. The morphology of the bonded interface before and after pressure application is shown in Fig. 4. Compared with the left image which shows the state before pressure application, the unjoined portions in the right image which shows the state after pressure application is significantly reduced, accounting for less than 10% of the entire bonded interface. The bonding sheet model deforms obviously at the bonded interface. The stress distribution in the system after pressure application in the right image shows that at the bonded interface, the stress in the contact area between the bonding surface of the chip and the bonding sheet ranges from 15 to 28 MPa, higher than the yield strength of the bonding sheet model (18 MPa). This theoretically proves that a bonding sheet with a yield strength of 18 MPa can undergo plastic deformation under a pressure of 15 MPa to conform to the chip.

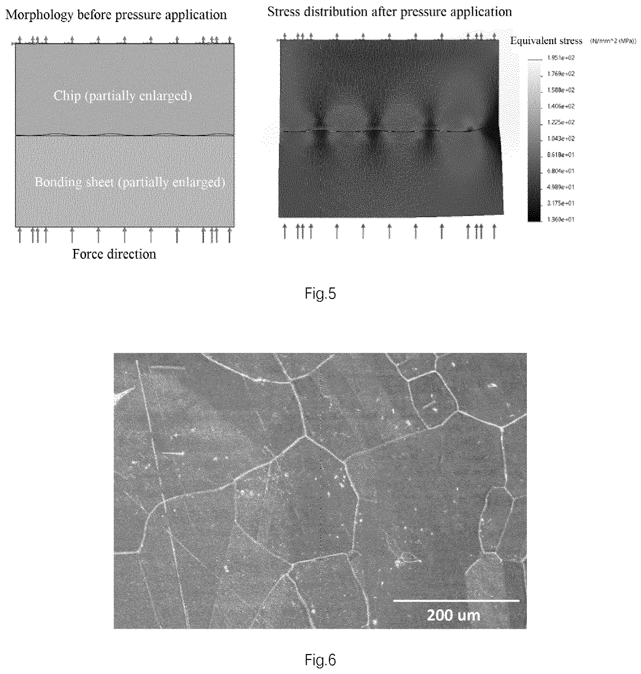

Simulation 4: the yield strength of the bonding sheet model is 100 MPa. A pressure equivalent to 40 MPa is applied to a bottom of the bonding sheet model in the direction shown in the figure (i.e., perpendicular to the bonding surface), while a top position of the chip is limited so as to perform static stress analysis. The morphology of the bonded interface before and after pressure application is shown in Fig. 5. Compared with the left image which shows the state before pressure application, the unjoined portions in the right image which shows the state after pressure application is significantly reduced, accounting for less than 10% of the entire bonded interface. The bonding sheet model deforms obviously at the bonded interface. The stress distribution in the system after pressure application in the right image shows that at the bonded interface, the stress in the contact area between the bonding surface of the chip and the bonding sheet ranges from 84 to 146 MPa, higher than the yield strength of the bonding sheet model (100 MPa). This theoretically proves that a bonding sheet with a yield strength of 100 MPa can undergo plastic deformation under a pressure of 40 MPa to conform to the chip.

Based on the above simulations, the inventors have found that by controlling the yield strength of the bonding sheet to be not more than 100 MPa, under different sintering pressures in the range of 15 to 40 MPa, the bonding sheet can undergo localized yielding to at least partially compensate for the roughness of the chip. This increases the effective bonded area and solves the problem of low shear strength caused by poor conformity between the bonding sheet and the bonding surface of the chip. Preferably, the bonding sheet as a whole still maintains a certain strength, so as to ensure the bonded strength while increasing the effective bonded area. This is because the shear strength of the bonded region is influenced by the tensile strength of the bonding sheet, and the tensile strength of a material is generally positively correlated with its yield strength. Therefore, while ensuring that the bonding sheet can undergo localized yielding to conform to the chip, a bonding sheet with a relatively high yield strength should be used. Accordingly, the present invention preferably requires the yield strength of the bonding sheet to be not less than 18 MPa.

The following is a description of how a bonding sheet of the present invention enhances the bonded assembly in conjunction with specific examples.

In Examples S1-S7 and Comparative Example C1, the copper substrates of the bonding sheets are commercially available rolled copper foils, with a thickness of 100 μm, a yield strength of 156 MPa, a tensile strength of 350 MPa, and an elongation of 7.8%. In Comparative Example C2, the copper substrate of the bonding sheet is also a commercially available rolled copper foil, with a thickness of 100 μm, a yield strength of 202 MPa, a tensile strength of 380 MPa, and an elongation of 5.4%.

## Preparation of Bonding Sheets

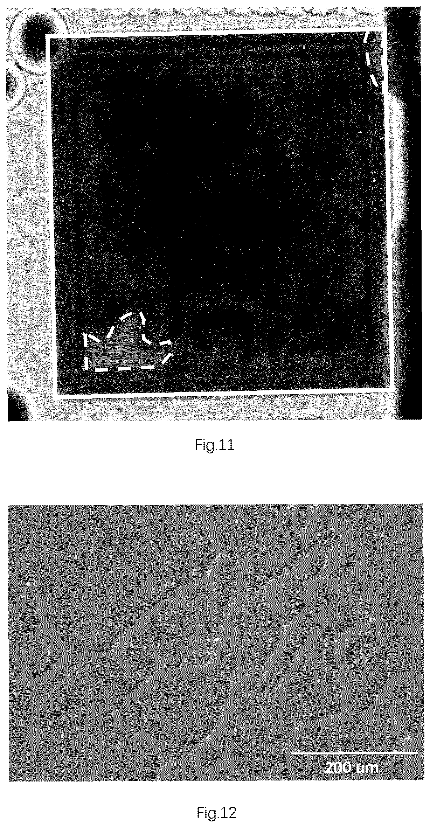

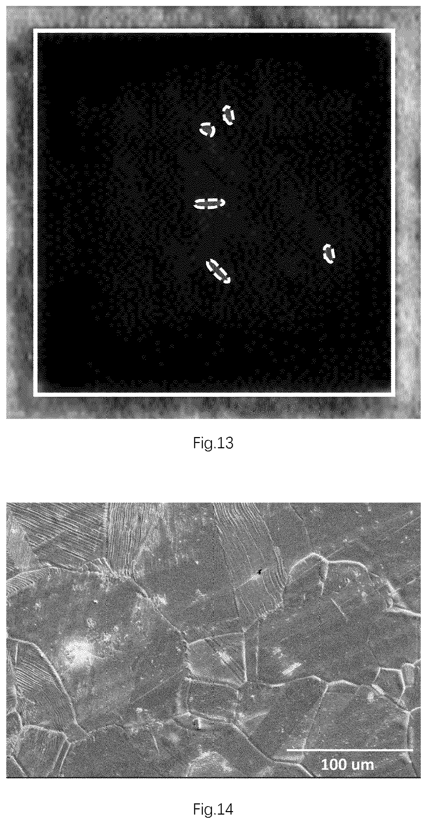

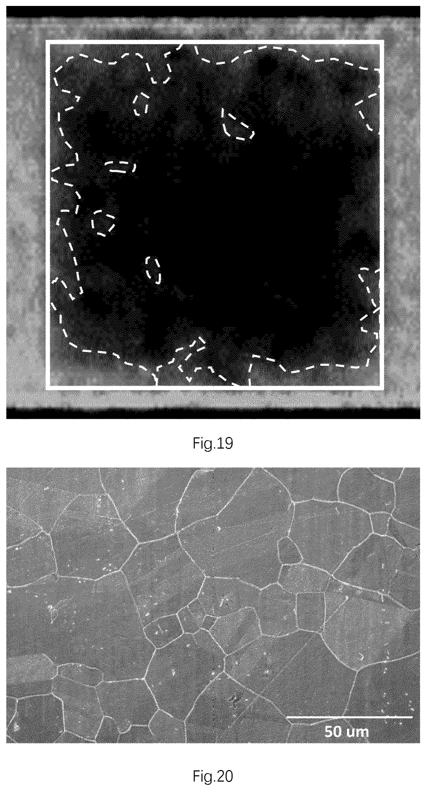

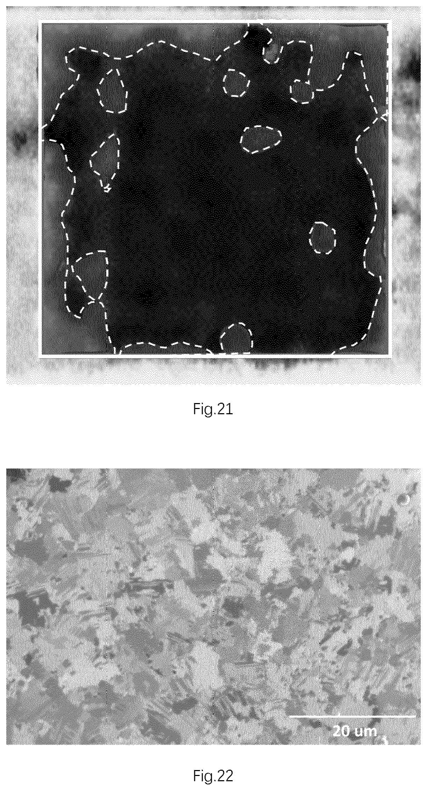

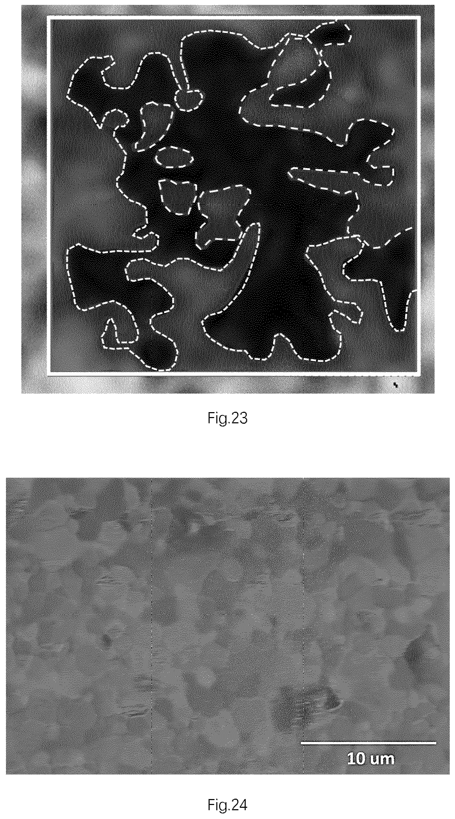

**1. Heat Treatment** Step: According to the parameters listed in Table 1, the copper substrates of Examples S1-S7 are subjected to heat treatment to obtain annealed copper substrates. Samples of the obtained annealed copper substrates are prepared for scanning electron microscopy (SEM) imaging (see Figs. 6, 8, 12, 14, 16, 18, and 20), and their average grain sizes are measured using methods known in the field and listed in Table 1. The copper substrates of Comparative Examples C1 and C2 do not undergo any heat treatment. Their surface morphologies are shown in Figs. 22 and 24 respectively, and the average grain sizes of Comparative Examples C1 and C2 are similarly measured using methods known in the field and listed in Table 1. In addition, for each example and comparative example, the yield strength thereof is tested using five samples to calculate an average value, which is listed in Table 2.

Table 1: Heat Treatment Conditions for Copper Substrates of S1-S7 and C1-C2

|  | Ambient Vacuum Degree/Torr | Holding Temperature/°C | Holding Time/hour | Average Grain Size/$\mu$m |
|---|---|---|---|---|
| S1 | $1.0 \times 10^{-3}$ | 850 | 16 | 132 |
| S2 | $1.0 \times 10^{-3}$ | 800 | 12 | 115 |
| S3 | $1.0 \times 10^{-3}$ | 650 | 6 | 92 |
| S4 | $1.0 \times 10^{-3}$ | 500 | 8 | 78 |
| S5 | $1.0 \times 10^{-3}$ | 450 | 2 | 50 |
| S6 | $1.0 \times 10^{-3}$ | 400 | 5 | 36 |
| S7 | $1.0 \times 10^{-3}$ | 400 | 2 | 30 |
| C1 | N/A | N/A | N/A | 5 |
| C2 | N/A | N/A | N/A | 2.5 |

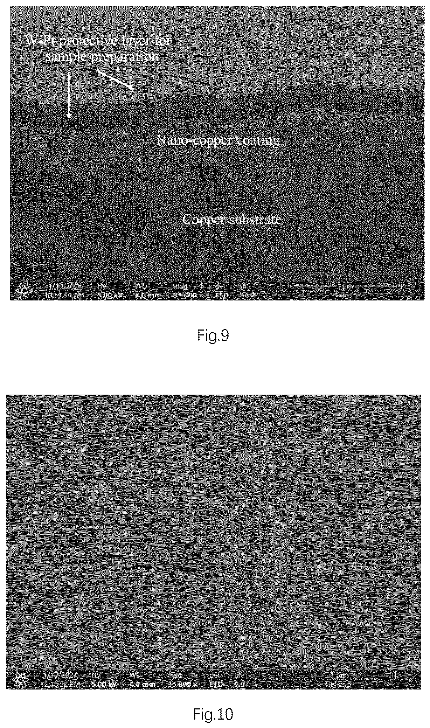

**2. Deposition Step:** A nano-copper layer is deposited on both surfaces of the annealed copper substrates of S1-S7 and the copper substrates of C1-C2, for example, in an electroplating manner. Taking Sample 1 of Example S2 as an example, the used electrolytic solution contains, for example, 120 g/L of anhydrous copper sulfate, 110 g/L of 98 wt.% concentrated sulfuric acid, 100 mg/L of sodium chloride, 420 mg/L of PEG20000, and 25 mg/L of Janus Green B. The electroplating deposition is performed at a current density of 0.08 A/cm$^2$ for a deposition time of 30 seconds. The obtained single-side nano-copper layer has a thickness of approximately 300 nm as shown in Fig. 9, and an average grain size of about 30 nm as shown in Fig. 10. Since the nano-copper layers in the samples of S1-S7 and C1-C2 are deposited on their respective copper substrates using the same process as Sample 1 of S2, no repeated characterization is provided here. Optionally, the nano-copper layer may be deposited on only one side of the annealed copper substrate/copper substrate. Optionally, at least two nano-metal layers may be deposited on at least one surface of the annealed copper substrate. The nano-metal layer may be made from a metal selected from: copper, gold, nickel, silver, platinum, and titanium.

After deposition, the bonding sheets of S1-S7 and C1-C2 are obtained. For each example and comparative example, five samples are tested to obtain an average value. Their corresponding average yield strength, average tensile strength, and average elongation are listed in Table 2. Compared with the average yield strength of the copper substrates, the average yield strength of the bonding sheets is only slightly higher, i.e., the average yield strength of the bonding sheets is controlled by the copper substrates. Thus, the expected yield strength of the bonding sheet can be achieved by controlling the yield strength of the copper substrate.

Each bonding sheet of S1-S7 comprises: a copper substrate having opposing first and second surfaces; and two nano-copper layers deposited on the first and second surfaces of the copper substrate, respectively, wherein the yield strength of the bonding sheet does not exceed 100 MPa (see Table 2 for details). Similarly, each bonding sheet of C1-C2 comprises: a copper substrate having opposing first and second surfaces; and two nano-copper layers deposited on the first and second surfaces of the copper substrate, respectively, wherein the yield strengths of the bonding sheets are 157 MPa and 203 MPa, respectively.

Table 2: Properties of the copper substrates and bonding sheets of S1-S7 and C1-C2

|  | Average Yield Strength of Copper Substrate/MPa | Average Yield Strength of Bonding Sheet/MPa | Average Tensile Strength of Bonding Sheet/MPa | Average Elongation of Bonding Sheet |
|---|---|---|---|---|
| S1 | 17.3 | 18.5 | 103.4 | 38.5% |
| S2 | 23.1 | 24.3 | 113.9 | 32.0% |
| S3 | 30.0 | 31.1 | 136.9 | 30.8% |

(continued)

|  | Average Yield Strength of Copper Substrate/MPa | Average Yield Strength of Bonding Sheet/MPa | Average Tensile Strength of Bonding Sheet/MPa | Average Elongation of Bonding Sheet |
|---|---|---|---|---|
| S4 | 49.2 | 50.0 | 203.2 | 28.0% |
| S5 | 62.0 | 63.4 | 210.5 | 23.2% |
| S6 | 84.0 | 85.2 | 226.3 | 16.5% |
| S7 | 97.9 | 98.8 | 252.6 | 11.5% |
| C1 | 156 | 157 | 351 | 7.6% |
| C2 | 202 | 203 | 382 | 5.4% |

Preferably, before deposition, surfaces of the annealed copper substrates of S1-S7 and the copper substrates of Comparative Examples C1-C2 are cleaned with dilute hydrochloric acid (HCl: $H_2O$ = 1:1) to remove possible oxide scales and the like. It should be understood that alternative methods may be employed to deposit the nano-metal layer on the surface of the copper substrate, such as evaporation, vapor deposition (e.g., magnetron sputtering), ion plating, etc. It should also be understood that the present invention is not limited to a nano-copper layer; the deposited layer may also be a nano-gold layer, nano-silver layer, nano-nickel layer, nano-titanium layer, or nano-platinum layer.

**Preparation of Bonded Assembly**

**Bonding Step:** First, the nano-copper layers of the bonding sheets of S1-S7 and C1-C2 are placed face-to-face with the respective bonding surfaces (which have not undergone additional treatment to achieve high flatness, so the perpendicular difference between the highest and lowest points on the bonding surfaces may reach up to 200 nm) of two chips. Then, thermocompression bonding is performed in a direction perpendicular to the bonding surfaces, wherein a bonding vacuum degree is $1 \times 10^{-3}$ Torr (e.g., in a helium-protected environment); a bonding temperature is 280°C; a bonding time is 15 minutes; and a bonding pressure is 25 MPa, thereby obtaining a bonded assembly according to the present invention. It should be understood that parameters for bonding are not limited to these values. For example, the bonding temperature may range from 250 to 350°C, the pressure may range from 15 to 40 MPa, and the bonding time may range from 10 to 30 minutes. Further preferably, the bonding temperature is 250 to 300°C, or the pressure is 20 to 30 MPa, or the bonding time is 10 to 20 minutes.

Each bonded assembly of S1-S7 comprises: a first chip; a second chip; and a bonding portion located between the first chip and the second chip to connect the two, wherein the bonding portion comprises a copper substrate, a first bonded interface on a first side of the copper substrate and a second bonded interface on the second side of the copper substrate opposite to the first side, the first bonded interface and the second bonded interface being formed by bonding nano-metal on the opposite sides of the copper substrate to the first chip and the second chip, respectively, wherein the shear strength of the bonded assembly is not less than 40 MPa (see Table 3). It should be understood that the chips in the bonded assembly may be replaced by other components, such as copper-clad ceramic substrates, heat sinks, etc.

To test the effective bonded area between the bonding sheet and the components to be bonded and the shear strength of the bonded assembly, a single chip and a bonding sheet are bonded using the method described above (hereinafter referred to as a single-sided bonded assembly). The effective bonded area ratio and shear strength tests are conducted on the single-sided bonded assembly (i.e., with only one bonded interface), to prevent inaccuracies in determining the unbonded regions on each side due to overlapping of the bonded regions in double-sided bonding. It should be noted that the measurement results of the single-sided bonded assembly are applicable to each bonded interface of a double-sided bonded assembly.

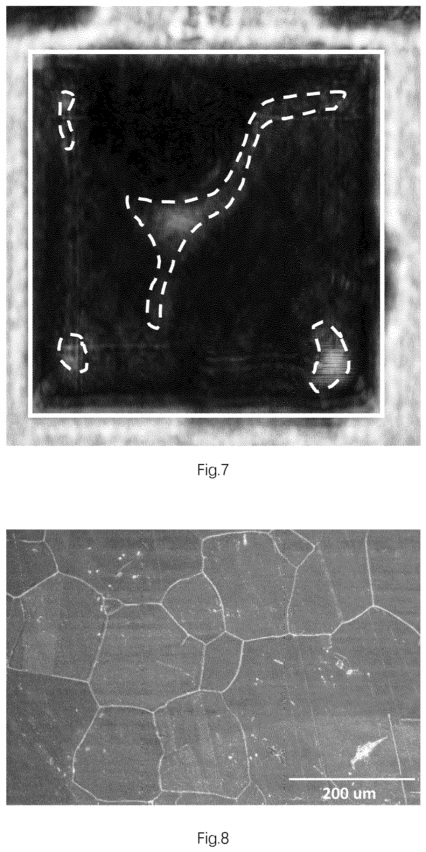

**Effective Bonded Area Ratio:** Taking Sample 1 of S1 as an example, the bonding location (10×10 mm bonded interface) of the single-sided bonded assembly obtained therefrom is inspected by acoustic scanning. Fig. 7 shows the scanning results for Sample 1 of S1, wherein a box indicates the bonding location. Inside the box, dark regions represent effective bonded regions, and regions outlined by irregular dashed lines represent delamination regions, i.e., unbonded (uncontacting) regions. Based on the proportion of the unbonded regions relative to the entire bonded area, the effective bonded area ratio is calculated to be 94.8% and listed in Table 3. Similarly, the effective bonded area ratios of five single-sided bonded assemblies for each of S1-S7 and C1-C2 are measured to obtain an average value, which is listed in Table 3.

**Shear Strength Testing:** The samples of five single-sided bonded assemblies of each of S1-S7 and C1-C2 are tested using the shear strength testing method described herein, to obtain an average shear strength value, which is listed in Table 3.

Table 3 Effective bonded area ratio and shear strength of single-side bonded assemblies AS1-AS7 and AC1-AC2 bonded from S1-S7 and C1-C2

| | | Sample 1 | Sample 2 | Sample 3 | Sample 4 | Sample 5 | Average Value |
|---|---|---|---|---|---|---|---|
| AS1 | Effective bonded area ratio (%) | 94.8 | 93.6 | 94.9 | 92.4 | 91.8 | 93.5 |
| | Shear strength (MPa) | 50.2 | 48.1 | 50.6 | 46.8 | 46.1 | 48.3 |
| AS2 | Effective bonded area ratio (%) | 90.3 | 97.6 | 96.3 | 96.1 | 97.7 | 95.6 |
| | Shear strength (MPa) | 53.0 | 55.9 | 54.8 | 54.3 | 56.1 | 54.8 |
| AS3 | Effective bonded area ratio (%) | 98.2 | 91.8 | 96.5 | 94.3 | 95.7 | 95.3 |
| | Shear strength (MPa) | 57.8 | 58.2 | 56.5 | 55.2 | 58.8 | 57.3 |
| AS4 | Effective bonded area ratio (%) | 90.1 | 80.5 | 78.2 | 81.8 | 85.4 | 83.2 |
| | Shear strength (MPa) | 52.8 | 46.1 | 45.7 | 47.0 | 49.3 | 48.2 |
| AS5 | Effective bonded area ratio (%) | 80.2 | 80.5 | 77.1 | 73.4 | 79.9 | 78.2 |
| | Shear strength (MPa) | 46.5 | 47.0 | 45.2 | 43.8 | 46.1 | 45.7 |
| AS6 | Effective bonded area ratio (%) | 73.1 | 74.5 | 70.4 | 69.7 | 72.3 | 72.0 |
| | Shear strength (MPa) | 44.0 | 44.7 | 40.1 | 39.4 | 42.8 | 42.2 |
| AS7 | Effective bonded area ratio (%) | 75.2 | 63.5 | 65.4 | 71.3 | 69.9 | 69.0 |
| | Shear strength (MPa) | 43.1 | 37.3 | 38.5 | 41.3 | 40.8 | 40.2 |
| AC1 | Effective bonded area ratio (%) | 51.0 | 48.5 | 44.2 | 46.7 | 48.2 | 47.7 |
| | Shear strength (MPa) | 35.6 | 31.5 | 28.1 | 29.6 | 31.0 | 31.2 |
| AC2 | Effective bonded area ratio (%) | 45.2 | 33.5 | 36.8 | 41.6 | 45.4 | 40.5 |
| | Shear strength (MPa) | 22.1 | 16.9 | 17.5 | 20.8 | 22.6 | 20.0 |

The yield strengths of the bonding sheets of S1-S7 in the present invention are in the range of 18 to 100 MPa. In contrast, the yield strengths of the bonding sheets of C1 and C2 are 157 MPa and 203 MPa, respectively. The average effective bonded area ratios of the bonded assemblies AS1-AS7 obtained using the bonding sheets of S1-S7 are not less than 69% (AS7), an improvement of at least 44% compared to AC1 and over 70% compared to AC2. Moreover, the average shear strengths are not less than 40.2 MPa, an improvement of at least 28% compared to AC1 and more than double that of AC2. This demonstrates that by controlling the yield strength of the bonding sheet, the present invention effectively solves the problem of small effective bonded area and low shear strength at the bonded interface of the bonded assembly when no additional treatment is performed on the bonding surface to achieve high flatness.

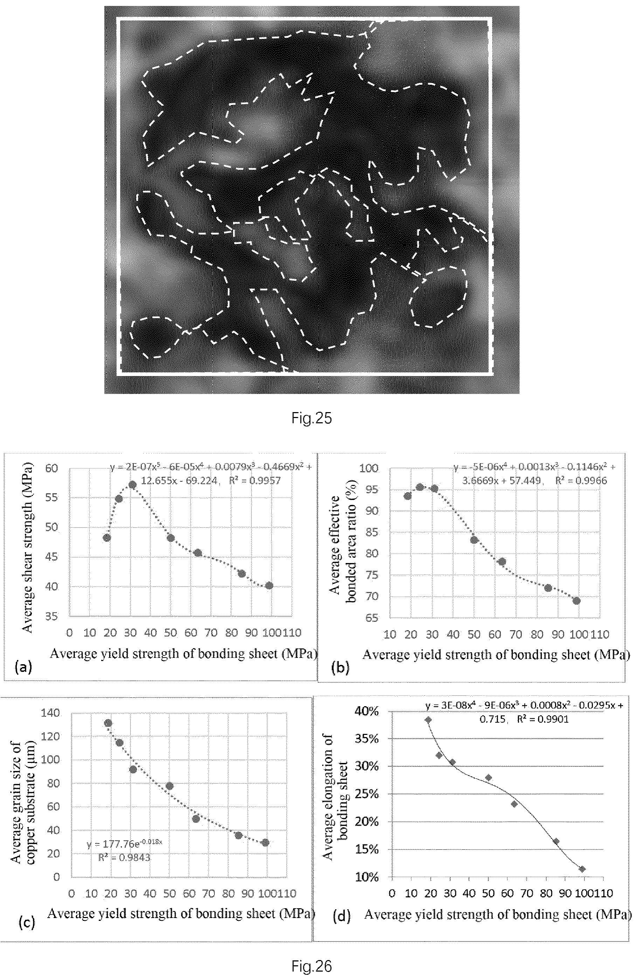

For AS1-AS7, as the yield strength increases, the shear strength of the finished bonded assembly rises to 57.3 MPa before gradually decreasing to 40.2 MPa, with the effective bonded area ratio exhibiting a similar trend. Based on experimental data, the relationships between the average yield strength of the bonding sheet and the average shear strength and the average effective bonded area ratio of the bonded assembly, the average grain size of the copper substrate in the bonding sheet, and the average elongation of the bonding sheet are fitted, as shown in Fig. 26. The goodness-of-fit $R^2$ for the curves are all close to 1, indicating excellent fitting. The following is an analysis in conjunction with the fitting curves and the examples.

Generally speaking, by controlling the yield strength of the bonding sheet within the range of 18 to 100 MPa, the obtained bonded assembly achieves a shear strength of not less than 40 MPa and an effective bonded area ratio of at least 67.5%. Correspondingly, the present invention controls the yield strength of the bonding sheet by controlling the yield strength of the copper substrate of the bonding sheet. Preferably, the yield strength of the copper substrate can be controlled by controlling the grain size of the copper substrate. In this case, to control the bonding sheet's yield strength to be within 18 to 100 MPa, the average grain size of the copper substrate should be in the range of 30 to 140 $\mu$m, correspondingly, the bonding sheet's elongation is not less than 11.5%.

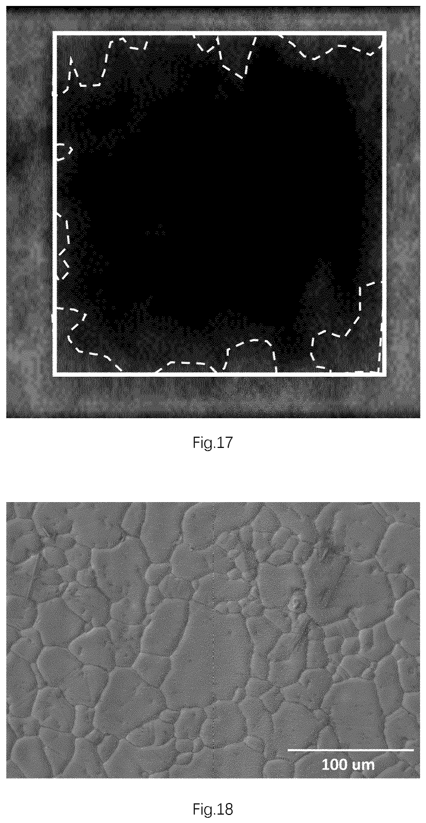

A comparison of Figs. 17, 19, and 21 (AS5-AS7) with Figs. 7, 11, 13, and 15 (AS1-AS4) reveals that compared with AS1-AS4, AS5-AS7 have larger unbonded regions, primarily located at the edges of the bonded interface. This is because the bonding sheets used in AS5-AS7 have higher yield strengths. Although localized plastic deformation can occur during bonding, the non-uniform stress distribution at the edges-compared with the uniform stress in the central region-makes it difficult for bonding sheets with relatively high yield strength to undergo appropriate plastic deformation.

Consequently, in these edge regions, the bonding sheet cannot conform adequately to the rough surface of the chip. Unlike unbonded regions away from the edges, unbonded regions at the edges are more likely to become failure initiation sites. Therefore, in order for the unbonded regions to be as far as possible from the edges of the bonded interface to ensure a shear strength of not less than 45 MPa, with reference to the fitted curves, the bonding sheet's yield strength should preferably be 18 to 67.5 MPa, whereby the effective bonded area ratio is at least 76%. Correspondingly, to control the yield strength of the bonding sheet to be 18 to 67.5 MPa with an elongation being not less than 23%, the average grain size of the copper substrate should preferably be within 50 to 140 $\mu$m.

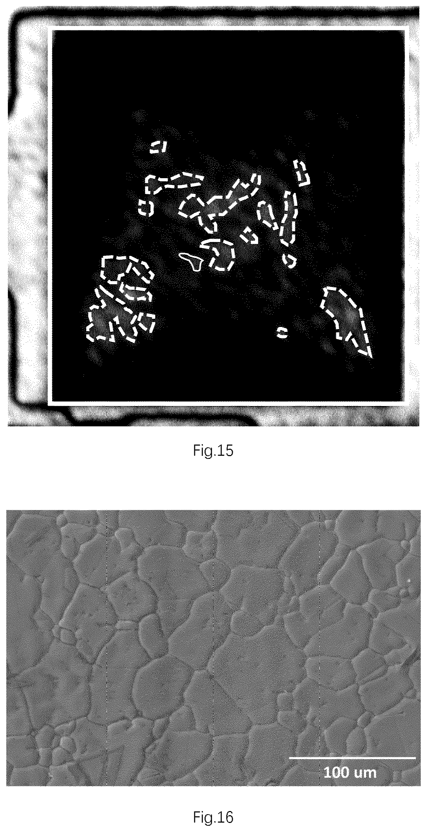

Comparing AS1 (Fig. 7) and AS4 (Fig. 15), although AS1 exhibits an obviously expanded bonded region (an increase of approximately 12.4%) compared to AS4, their shear strengths are almost the same. This is because, as shown in Fig. 7, AS1's unbonded region is in an elongated crescent shape, continuously extending along the diagonal of the bonded zone. In contrast, Fig. 15 shows that AS4's unbonded regions are scattered without forming any continuous elongated unbonded regions. Consequently, under identical shear testing conditions, the unbonded region extending continuously along the diagonal of the bonded zone in AS1 weakens the effects brought by the increase in the bonded region, resulting in almost the same shear strength as that of AS4. The elongated crescent-shaped unbonded region is caused by excessive localized deformation or even tearing due to low yield strength of the bonding sheet. The presence of cracks not only adversely affects shear strength but also poses reliability risks during subsequent use. Therefore, to further avoid continuous unbonded regions like the one in an elongated crescent shape and increase the shear strength to not less than 50 MPa, with reference to the fitted curves, the bonding sheet's yield strength is preferably 20 to 46.5 MPa, whereby the effective bonded area ratio will be at least 86%. Correspondingly, to achieve a bonding sheet yield strength of 20 to 46.5 MPa with an elongation being 27.5-36%, the average grain size of the copper substrate is preferably controlled within the range of 75 to 122.5 $\mu$m.

The effective bonded area ratio and shear strength of AS2 and AS3 are significantly higher compared with other examples, making them the more preferred embodiments of the present invention. Compared with AS2, although AS3 has an effective bonded area ratio similar to that of AS2, its shear strength is approximately 4.6% higher. The superior shear strength of AS3 over that of AS2 is due to the fact that the yield strength of the bonding sheet of AS3 increases to 31.1 MPa from 24.3 MPa in S2. The increased yield strength not only allows the bonding sheet to meet the deformation requirement of localized yielding under the current sintering pressure (25 MPa) but also brings about a synchronous increase in tensile strength through the improvement of yield strength, thereby improving the strength of the bonding sheet and in turn the shear strength of the bonded region. In other words, when similar effective bonded areas can be achieved, choosing a higher yield strength (i.e., higher tensile strength) can arrive at a higher shear strength. Therefore, to further improve shear strength to be not less than 55 MPa, in view of the fitted curves, the yield strength of the bonding sheet is preferably 23 to 36 MPa, whereby the effective bonded area ratio will be at least 92.5%. Preferably, the bonding sheet yield strength of 23 to 36 MPa with an elongation being 29-34% is achieved by controlling the average grain size of the copper substrate within a range of 90 to 115 $\mu$m.

In summary, by controlling the bonding sheet's yield strength, the present invention enables localized deformation of the bonding sheet during bonding, thereby improving conformity between the bonding sheet and the unflattened bonding surface of the component to be bonded. This increases the effective bonded area of the bonded interface, enhancing the shear strength and its service stability of the resulting bonded assembly.

The above examples and experimental data are intended to describe the present invention by way of example. Those skilled in the art should be clear that the invention is not limited to these examples, and various modifications can be made without departing from the scope of protection of the present invention.

## Claims

1. A bonding sheet, comprising:

   a copper substrate having opposing first and second surfaces; and
   at least one nano-metal layer deposited on at least one of the first and second surfaces of the copper substrate, wherein a yield strength of the bonding sheet is not greater than 100 MPa.

2. The bonding sheet according to claim 1, wherein the yield strength of the bonding sheet is in the range of 18 to 100 MPa, preferably in the range of 18 to 67.5 MPa, preferably in the range of 20 to 46.5 MPa, and yet preferably in the range of 23 to 36 MPa.

3. The bonding sheet according to claim 1 or 2, wherein an average grain size of the copper substrate is in the range of 30 to 140 $\mu$m, preferably in the range of 50 to 140 $\mu$m, preferably in the range of 75 to 122.5 $\mu$m, and yet preferably in the range of 92 to 115 $\mu$m.

4. The bonding sheet according to claim 1 or 2, wherein an elongation of the bonding sheet is not less than 11.5%, preferably not less than 23%, preferably in the range of 27.5% to 36%, and yet preferably in the range of 29% to 34%.

5. The bonding sheet according to claim 1 or 2, wherein an average grain size of the nano-metal layer is in the range of 5 to 500 nm, preferably in the range of 5 to 100 nm; and an average thickness of the nano-metal layer is in the range of 100 nm to 10 $\mu$m, preferably in the range of 500 nm to 5 $\mu$m.

6. The bonding sheet according to claim 1 or 2, wherein the nano-metal layer is made from a metal selected from: copper, gold, nickel, silver, platinum and titanium, and wherein at least two nano-metal layers are stacked on at least one of the first and second surfaces.

7. A method for preparing a bonding sheet, comprising:

Step A: providing a copper substrate having opposing first and second surfaces;
Step B: annealing the copper substrate under vacuum to obtain an annealed copper substrate, an average grain size of the annealed copper substrate being in the range of 30 to 140 $\mu$m;
Step C: depositing at least one nano-metal layer on at least one of the first and second surfaces of the annealed copper substrate to obtain the bonding sheet.

8. The method according to claim 7, wherein a yield strength of the annealed copper substrate is not greater than 100 MPa, and a yield strength of the bonding sheet is in the range of 18 to 100 MPa, preferably in the range of 18 to 67.5 MPa, preferably in the range of 20 to 46.5 MPa, and yet preferably in the range of 23 to 36 MPa; wherein an average grain size of the copper substrate is in the range of 50 to 140 $\mu$m, preferably in the range of 75 to 122.5 $\mu$m, and yet preferably in the range of 92 to 115 $\mu$m.

9. The method according to claim 7 or 8, wherein in Step B, a vacuum degree is $1.0 \times 10^{-3}$ Torr, an annealing temperature is 400 to 850°C, and a holding time is 2 to 16 hours; yet preferably, the annealing temperature is 500 to 800°C, and the holding time is 6 to 12 hours.

10. The method according to claim 7 or 8, wherein an average grain size of the nano-metal layer is in the range of 5 to 500 nm, preferably in the range of 5 to 100 nm.

11. The method according to claim 7 or 8, comprising depositing at least two stacked nano-metal layers on at least one of the first and the second surfaces, wherein the nano-metal layer is made from a metal selected from: copper, gold, nickel, silver, platinum, and titanium.

12. The method according to claim 7 or 8, wherein the nano-metal layer is a nano-copper layer, which is deposited by electroplating as follows: an electrolytic solution contains 100 to 150 g/L of anhydrous copper sulfate, 80 to 150 g/L of 98 wt.% concentrated sulfuric acid, 50 to 150 mg/L of sodium chloride, 350 to 480 mg/L of PEG20000, and 20 to 40 mg/L of Janus Green B, wherein the current density of the electroplating deposition is 0.05 to 0.15 A/cm$^2$, and the deposition time is 10 to 300 seconds.

13. A bonded assembly, comprising:

a first substrate;
a second substrate; and
a bonding portion located between the first substrate and the second substrate to connect the two, wherein the bonding portion comprises a copper substrate, a first bonded interface on a first side of the copper substrate, and a second bonded interface on a second side of the copper substrate opposite to the first side, the first bonded interface and the second bonded interface being formed by bonding nano-metal on the opposite sides of the copper substrate with the first substrate and the second substrate, respectively,
wherein a shear strength of the bonded assembly is not less than 40 MPa.

14. The bonded assembly according to claim 13, wherein an average grain size of the copper substrate is in the range of 30 to 140 $\mu$m, preferably in the range of 50 to 140 $\mu$m, preferably in the range of 75 to 122.5 $\mu$m, and yet preferably in the range of 92 to 115 $\mu$m.

15. The bonded assembly according to claim 13 or 14, wherein an effective bonded area of the first bonded interface and/or the second bonded interface is not less than 67.5% of the entire interface area, preferably not less than 76%, and more preferably not less than 86%.

16. The bonded assembly according to claim 13 or 14, wherein the shear strength of the bonded assembly is not less than 45 MPa, yet preferably not less than 50 MPa, and more preferably not less than 55 MPa.

17. A method for producing a bonded assembly, comprising:

Step A: providing a first substrate having a first outer surface, a second substrate having a second outer surface, and a bonding sheet, wherein the bonding sheet comprises: a copper substrate having opposing first and second surfaces; a first nano-metal layer on the first surface of the copper substrate; and a second nano-metal layer on the second surface of the copper substrate, wherein a yield strength of the bonding sheet is not greater than 100 MPa;
Step B: arranging the first nano-metal layer of the bonding sheet in surface contact with the first outer surface of the first substrate and the second nano-metal layer of the bonding sheet in surface contact with the second outer surface of the second substrate to form a stacked structure;
Step C: performing thermocompression bonding on the stacked structure to bond the first substrate, the second substrate, and the bonding sheet together, thereby obtaining the bonded assembly, wherein a shear strength of the bonded assembly is not less than 40 MPa.

18. The method according to claim 17, wherein in Step C, the thermocompression bonding is performed as follows: a pressure of 15 to 40 MPa is applied from above and below the stacked structure in a helium-protected environment at a temperature of 250 to 350°C, with a holding time of 10 to 30 minutes.

19. The method according to claim 17, wherein when the first substrate and/or the second substrate is placed horizontally, the perpendicular difference between the highest point and the lowest point on the first outer surface and the second outer surface does not exceed 200 nm.

20. The method according to any one of claims 17-19, wherein the yield strength of the bonding sheet is in the range of 18 to 100 MPa, preferably in the range of 18 to 67.5 MPa, preferably in the range of 20 to 46.5 MPa, and yet preferably in the range of 23 to 36 MPa; wherein an average grain size of the copper substrate is in the range of 30 to 140 $\mu$m, preferably in the range of 50 to 140 $\mu$m, preferably in the range of 75 to 122.5 $\mu$m, and yet preferably in the range of 92 to 115 $\mu$m.

Fig.1

Morphology before pressure application    Stress distribution after pressure application

Force direction

Fig.2

Morphology before pressure application  Stress distribution after pressure application

Fig.3

Morphology before pressure application  Stress distribution after pressure application

Fig.4

Morphology before pressure application     Stress distribution after pressure application

Force direction

Fig.5

Fig.6

Fig.7

Fig.8

Fig.9

Fig.10

Fig.11

Fig.12

Fig.13

Fig.14

Fig.15

Fig.16

Fig.17

Fig.18

Fig.19

Fig.20

Fig.21

Fig.22

Fig.23

Fig.24

Fig.25

(a) $y = 2E\text{-}07x^5 - 6E\text{-}05x^4 + 0.0079x^3 - 0.4669x^2 + 12.655x - 69.224$, $R^2 = 0.9957$

Average shear strength (MPa) vs Average yield strength of bonding sheet (MPa)

(b) $y = -5E\text{-}06x^4 + 0.0013x^3 - 0.1146x^2 + 3.6669x + 57.449$, $R^2 = 0.9966$

Average effective bonded area ratio (%) vs Average yield strength of bonding sheet (MPa)

(c) $y = 177.76e^{-0.018x}$, $R^2 = 0.9843$

Average grain size of copper substrate (μm) vs Average yield strength of bonding sheet (MPa)

(d) $y = 3E\text{-}08x^4 - 9E\text{-}06x^3 + 0.0008x^2 - 0.0295x + 0.715$, $R^2 = 0.9901$

Average elongation of bonding sheet vs Average yield strength of bonding sheet (MPa)

Fig.26

## INTERNATIONAL SEARCH REPORT

| International application No. |
|---|
| **PCT/CN2024/077900** |

### A. CLASSIFICATION OF SUBJECT MATTER

B23K35/30(2006.01)i; B23K35/02(2006.01)i

According to International Patent Classification (IPC) or to both national classification and IPC

### B. FIELDS SEARCHED

Minimum documentation searched (classification system followed by classification symbols)

IPC:B23K

Documentation searched other than minimum documentation to the extent that such documents are included in the fields searched

Electronic data base consulted during the international search (name of data base and, where practicable, search terms used)

CNKI; VEN; CNTXT; CNABS; ENTXTC: 焊, 铜, 纳米, 面, 屈服强度, 强度, mpa, 兆帕, 焊片, solder???, weld???, copper, cuprum, cu, nanometer, nm, side, yield???, strength

### C. DOCUMENTS CONSIDERED TO BE RELEVANT

| Category* | Citation of document, with indication, where appropriate, of the relevant passages | Relevant to claim No. |
|---|---|---|
| X | CN 112440025 A (TSINGHUA UNIVERSITY) 05 March 2021 (2021-03-05) description, paragraphs 0021-0125 | 1-20 |
| A | CN 204558495 U (SHENZHEN HUAGUANGDA TECHNOLOGY CO., LTD.) 12 August 2015 (2015-08-12) entire document | 1-20 |
| A | US 2017225277 A1 (KYUNG DONG ONE CORP.) 10 August 2017 (2017-08-10) entire document | 1-20 |
| A | KR 20200082107 A (HYUNDAI MOTOR CO., LTD. et al.) 08 July 2020 (2020-07-08) entire document | 1-20 |

☐ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **17 May 2024** | **27 May 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/077900**

| Patent document cited in search report | | | Publication date (day/month/year) | Patent family member(s) | | | Publication date (day/month/year) |
|---|---|---|---|---|---|---|---|
| CN | 112440025 | A | 05 March 2021 | None | | | |
| CN | 204558495 | U | 12 August 2015 | None | | | |
| US | 2017225277 | A1 | 10 August 2017 | JP | 2019188475 | A | 31 October 2019 |
| | | | | JP | 6842500 | B2 | 17 March 2021 |
| | | | | KR | 20160021648 | A | 26 February 2016 |
| | | | | KR | 101671062 | B1 | 31 October 2016 |
| | | | | JP | 2017528327 | A | 28 September 2017 |
| | | | | JP | 2021053704 | A | 08 April 2021 |
| | | | | JP | 2019188474 | A | 31 October 2019 |
| | | | | WO | 2016028058 | A1 | 25 February 2016 |
| | | | | EP | 3184234 | A1 | 28 June 2017 |
| | | | | EP | 3184234 | A4 | 24 January 2018 |
| | | | | EP | 3184234 | B1 | 30 June 2021 |
| | | | | US | 10286498 | B2 | 14 May 2019 |
| KR | 20200082107 | A | 08 July 2020 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 110640354 A

- WO 2022127776 A1